# EUROPEAN PATENT APPLICATION

(11) **EP 4 782 848 A1**
(43) Date of publication of application: **29.07.2026**
(21) Application number: 26153465.5
(22) Date of filing: 22.01.2026
(51) Int. Cl.: G01R 19/25, G01R 21/133

(54) **ELECTRICAL DEVICE STATE RECOGNITION METHOD AND APPARATUS, ELECTRONIC DEVICE, AND STORAGE MEDIUM**

(30) Priority: 26.01.2025 CN 202510124975
(71) Applicant: Siemens Aktiengesellschaft, 80333 München (DE)
(72) Inventor: Pang, Jian Guo, Shanghai, 200082 (CN); Chen, Wei Gang, Shanghai, 200082 (CN)
(74) Representative: Isarpatent

(57) **Abstract**

The present disclosure provides an electrical device state recognition method and apparatus, an electronic device, and a storage medium. The electrical device state recognition method includes: obtaining overall profile information and detail information based on electrical data of an electrical device, where the overall profile information is used to indicate an overall profile of a curve corresponding to the electrical data, and the detail information is used to indicate details of the curve; determining first state information of the electrical device based on the overall profile information; determining second state information of the electrical device based on the detail information; and determining a state of the electrical device based on the first state information and the second state information. This solution can improve accuracy of electrical device state recognition.

## Description

### TECHNICAL FIELD

The present disclosure relates to the field of electrical engineering technologies, and in particular, to an electrical device state recognition method and apparatus, an electronic device, and a storage medium.

### BACKGROUND

In fields such as predictive maintenance and non-intrusive load monitoring (NILM), state recognition of electrical devices with a plurality of states is of great importance, as it can improve effectiveness of predictive maintenance and lay a foundation for NILM.

Currently, a classifier is trained using measured electrical data, and after electrical data of an electrical device is input into the classifier, a state of the electrical device is recognized by the classifier.

However, based on shape features, electrical data of electrical devices may be classified into electrical data corresponding to continuously varying curves and electrical data corresponding to discontinuously varying curves. The classifier trained using the measured electrical data cannot accurately recognize states of an electrical device whose electrical data corresponds to continuously varying curves, resulting in low accuracy of electrical device state recognition.

### SUMMARY

In view of this, an electrical device state recognition method and apparatus, an electronic device, and a storage medium according to the present disclosure can improve accuracy of a state recognition result of an electrical device.

According to a first aspect of embodiments of the present disclosure, an electrical device state recognition method is provided, including: obtaining overall profile information and detail information based on electrical data of an electrical device, where the overall profile information is used to indicate an overall profile of a curve corresponding to the electrical data, and the detail information is used to indicate details of the curve; determining first state information of the electrical device based on the overall profile information; determining second state information of the electrical device based on the detail information; and determining a state of the electrical device based on the first state information and the second state information.

In a possible implementation, the obtaining overall profile information and detail information based on electrical data of an electrical device includes: obtaining amplitude information and temporal information based on the electrical data of the electrical device; obtaining the overall profile information based on the amplitude information; and obtaining the detail information based on the amplitude information and the temporal information. The amplitude information can reflect an overall shape of the curve corresponding to the electrical data, and the temporal information can intuitively reflect a shape change of the curve corresponding to the electrical data. The overall profile information is determined based on the amplitude information, and the detail information is determined based on the amplitude information and the temporal information, ensuring that the overall profile information can accurately indicate the overall profile of the curve corresponding to the electrical data, and the detail information can indicate the details of the curve corresponding to the electrical data. Then, when the state of the electrical device is recognized based on the overall profile information and the detail information, accuracy of a state recognition result can be ensured.

In a possible implementation, the obtaining amplitude information and temporal information based on the electrical data of the electrical device includes: performing feature extraction on the electrical data through a first extraction algorithm, to obtain the amplitude information, where the first extraction algorithm includes at least one of a minimum filtering algorithm, a median filtering algorithm, a maximum filtering algorithm, a reshaping algorithm, or a mathematical morphology algorithm; and performing feature extraction on the electrical data through a second extraction algorithm, to obtain the temporal information, where the second extraction algorithm includes at least one of a filtering algorithm, a reshaping algorithm, or an event detection algorithm. The amplitude information is extracted from the electrical data through the minimum filtering algorithm, the median filtering algorithm, the maximum filtering algorithm, the reshaping algorithm, or the mathematical morphology algorithm, so that the amplitude information can reflect the overall shape of the curve corresponding to the electrical data. The temporal information is extracted from the electrical data through the filtering algorithm, the reshaping algorithm, or the event detection algorithm, so that the temporal information can intuitively reflect the shape change of the curve corresponding to the electrical data.

In a possible implementation, the obtaining the overall profile information based on the amplitude information includes: extracting an envelope of reactive power included in the amplitude information as the overall profile information; and the obtaining the detail information based on the amplitude information and the temporal information includes: extracting a temporal feature from neutral current included in the temporal information, extracting, based on the temporal feature, a curve segment from a curve corresponding to active power included in the amplitude information, and determining the curve segment as the detail information. An envelope of the active power is extracted as the overall profile information, and a curve segment in a curve corresponding to the reactive power is extracted as the detail information based on the temporal feature extracted from the neutral current, ensuring that the overall profile information can indicate the overall profile of the curve corresponding to the electrical data, and the detail information can indicate the details of the curve corresponding to the electrical data, and reduce redundant information in the overall profile information and the detail information, thereby ensuring accuracy of the state recognition result obtained based on the overall profile information and the detail information.

In a possible implementation, the determining first state information of the electrical device based on the overall profile information includes: inputting the overall profile information into a clustering model, to determine a target category to which the overall profile information belongs; and determining state information corresponding to the target category as the first state information. Because the overall profile information is shape information of the electrical data, the first state information is determined based on the overall profile information in a clustering manner, thereby ensuring accuracy of the determined first state information.

In a possible implementation, the determining second state information of the electrical device based on the detail information includes: determining, from a plurality of reference curves, a target reference curve with the highest similarity to a curve corresponding to the detail information; and determining state information corresponding to the target reference curve as the second state information. Because the detail information is shape information of the electrical data, the second state information is determined based on the detail information by calculating the similarities between the curves, so that the target reference curve with the highest similarity to the curve corresponding to the detail information can be matched, and the state information corresponding to the target reference curve can then be determined as the second state information, thereby ensuring accuracy of the determined second state information.

In a possible implementation, the determining a state of the electrical device based on the first state information and the second state information includes: combining a state indicated by the first state information with a state indicated by the second state information, to obtain the state of the electrical device. The first state information indicates a first sub-state of the electrical device, and the second state information indicates a second sub-state of the electrical device. The first sub-state and the second sub-state are combined to obtain the state of the electrical device, so that the state recognition result of the electrical device is more refined and comprehensive, thereby ensuring accuracy of the state recognition result of the electrical device.

According to a second aspect of the embodiments of the present disclosure, an electrical device state recognition apparatus is provided, including: an extraction unit, configured to obtain overall profile information and detail information based on electrical data of an electrical device, where the overall profile information is used to indicate an overall profile of a curve corresponding to the electrical data, and the detail information is used to indicate details of the curve; a first mapping unit, configured to determine first state information of the electrical device based on the overall profile information; a second mapping unit, configured to determine second state information of the electrical device based on the detail information; and a recognition unit, configured to determine a state of the electrical device based on the first state information and the second state information.

According to a third aspect of the embodiments of the present disclosure, an electronic device is provided, including: a processor, a memory, a communication interface, and a bus, where the processor, the memory, and the communication interface communicate with each other via the bus; and the memory is configured to store at least one executable instruction, where the executable instruction causes the processor to perform operations corresponding to the electrical device state recognition method according to the first aspect.

According to a fourth aspect of the embodiments of the present disclosure, a computer-readable storage medium is provided, where the computer-readable storage medium stores computer instructions, and the computer instructions, when executed by a processor, cause the processor to perform the electrical device state recognition method according to the first aspect.

According to a fifth aspect of the embodiments of the present disclosure, a computer program product is provided, where the computer program product is tangibly stored on a computer-readable medium and includes computer-executable instructions, and the computer executable instructions, when executed, cause at least one processor to perform the electrical device state recognition method according to the first aspect.

It can be known from the foregoing technical solutions that the overall profile information and the detail information are obtained based on the electrical data of the electrical device. Both the overall profile information and the detail information are shape information corresponding to the electrical data, indicating shape features of the curve corresponding to the electrical data. However, the shape features of the curves corresponding to the electrical data of the electrical device differ significantly in different states. Therefore, the sub-states of the electrical device can be determined from two dimensions based on the overall profile information and the detail information, to obtain the corresponding first state information and second state information, and the state of the electrical device can then be determined based on the first state information and the second state information. Because the combined overall profile information and detail information are highly distinctive for different states of the electrical device, the state of the electrical device can be recognized from two dimensions based on the overall profile information and the detail information, so that the state of the electrical device can be accurately determined, thereby ensuring accuracy of the obtained state recognition result.

### BRIEF DESCRIPTION OF THE DRAWINGS

FIG. 1 is a flowchart of an electrical device state recognition method according to an embodiment of the present disclosure;
FIG. 2 is a schematic diagram of curves corresponding to active power and neutral current according to an embodiment of the present disclosure;
FIG. 3 is a schematic diagram of an electrical device state recognition apparatus according to an embodiment of the present disclosure; and
FIG. 4 is a schematic diagram of an electronic device according to an embodiment of the present disclosure.

### List of reference numerals:

| | | | | | |
|---|---|---|---|---|---|
| 100: | Electrical device state recognition method | 101 to 104: | Method steps | 300: | Electrical device state recognition apparatus |
| 301: | Extraction unit | 302: | First mapping unit | 303: | Second mapping unit |
| 304: | Recognition unit | 400: | Electronic device | 402: | Processor |
| 404: | Communication interface | 406: | Memory | 408: | Bus |
| 410: | Program | | | | |

### DETAILED DESCRIPTION

To make a person skilled in the art understand technical solutions in embodiments of the present disclosure better, the following clearly and completely describes the technical solutions in the embodiments of the present disclosure with reference to the accompanying drawings in the embodiments of the present disclosure. Apparently, the described embodiments are only some of the embodiments of the present disclosure rather than all of the embodiments. All other embodiments obtained by a person of ordinary skill in the art based on the embodiments of the present disclosure shall fall within the protection scope of the embodiments of the present disclosure.

For an electrical device with a plurality of states, components of the electrical device that operate in different states or operating intensities of the components are different. An accumulated operating duration of the components in the electrical device and an operating duration of the components under different operating intensities can be determined through state recognition. Then, predictive maintenance and energy-saving control can be performed on the electrical device based on the accumulated operating duration and the operating duration under the different operating intensities, thereby ensuring effectiveness of the predictive maintenance on the electrical device. In the related art, when state recognition is performed on an electrical device with a plurality of states, a classifier is pre-trained using a plurality of pieces of measured electrical data. After the electrical data of the electrical device is input into the classifier, a state of the electrical device is recognized by the classifier. However, for an electrical device whose electrical data corresponds to continuously varying curves, because the electrical data corresponding to continuously varying curves is difficult to describe through a statistical method, the classifier cannot accurately recognize the state of the electrical device, resulting in low accuracy of an obtained state recognition result.

In the embodiments of the present disclosure, overall profile information and detail information are extracted from the electrical data of the electrical device. The overall profile information can indicate an overall profile of the curve corresponding to the electrical data, and the detail information can indicate details of the curve corresponding to the electrical data. Then, the state of the electrical device is recognized based on the overall profile information and the detail information. The overall profile information and the detail information are shape information of the electrical data. The combined overall profile information and detail information are highly distinctive for different states of the electrical device, so that the states of the electrical device with a plurality of states can be accurately recognized by performing state recognition on the electrical device based on the overall profile information and the detail information, thereby improving accuracy of the obtained state recognition result.

The following describes in detail an electrical device state recognition method and apparatus, an electronic device, and a storage medium according to the embodiments of the present disclosure with reference to the accompanying drawings.

### Electrical device state recognition method

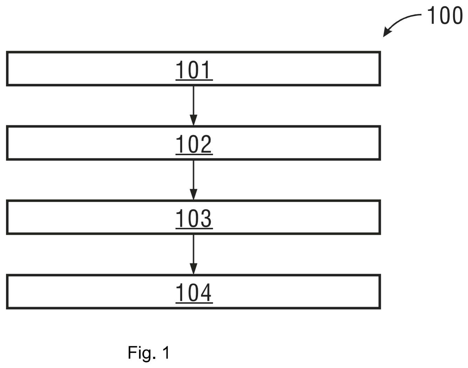

FIG. 1 is a flowchart of an electrical device state recognition method according to an embodiment of the present disclosure. As shown in FIG. 1, the electrical device state recognition method 100 includes the following steps.

Step 101: Obtain overall profile information and detail information based on electrical data of an electrical device.

The electrical device in this embodiment of the present disclosure is an electrical device with a plurality of states, for example, a high-temperature oven or a cleaning device for producing a printed circuit board (PCB). The electrical data may include a plurality of types of data such as active power, reactive power, and current. The electrical data may be obtained through measurement by a smart meter dedicated to the electrical device, or may be obtained by analyzing data obtained through measurement by a main meter for non-intrusive load monitoring. The source of the electrical data is not limited in this embodiment of the present disclosure.

The overall profile information and the detail information may be determined based on the electrical data, and both the overall profile information and the detail information are shape information corresponding to the electrical data. The overall profile information can indicate an overall profile of a curve corresponding to at least some of the electrical data. The overall profile information of the electrical device may differ in different states. The detail information can indicate details of the curve corresponding to at least some of the electrical data, for example, a start time and an end time of a curve segment with a specific shape. The detail information of the electrical device may differ in different states.

Combinations of the overall profile information and the detail information of the electrical device are different in different states, but the electrical device may have the same overall profile information or the same detail information in different states. For example, in a first state of the electrical device, the overall profile information is overall profile information 1, and the detail information is detail information 1; in a second state of the electrical device, the overall profile information is overall profile information 1, and the detail information is detail information 2; in a third state of the electrical device, the overall profile information is overall profile information 2, and the detail information is detail information 1; and in a fourth state of the electrical device, the overall profile information is overall profile information 2, and the detail information is detail information 2.

Step 102: Determine first state information of the electrical device based on the overall profile information.

A state of the electrical device may include a first sub-state and a second sub-state, and a combination of the first sub-state and the second sub-state is the state of the electrical device. The first sub-state of the electrical device may be determined through the overall profile information, and different overall profile information corresponds to different first sub-states.

After the overall profile information is obtained, the first sub-state corresponding to the overall profile information is determined, and the first state information capable of indicating the first sub-state is then obtained. For example, if the electrical device is a high-temperature oven, the first sub-state includes a heating start phase and a heating maintenance phase. Based on the obtained overall profile information, if the first sub-state of the high-temperature oven is determined as the heating start phase, the first state information capable of indicating that the high-temperature oven is in the heating start phase is obtained.

Step 103: Determine second state information of the electrical device based on the detail information.

The second sub-state of the electrical device may be determined through the detail information, and different detail information corresponds to different second sub-states. After the detail information is obtained, the second sub-state corresponding to the detail information is determined, and the second state information capable of indicating the second sub-state is then obtained. For example, if the electrical device is a high-temperature oven, the second sub-state includes: no blowing, first-level blowing, and second-level blowing. Based on the obtained detail information, if the second sub-state of the high-temperature oven is determined as first-level blowing, the second state information capable of indicating that the high-temperature oven is operating at first-level blowing is obtained.

Step 104: Determine the state of the electrical device based on the first state information and the second state information.

Because the first state information can indicate the first sub-state of the electrical device, the second state information can indicate the second sub-state of the electrical device, and the first sub-state and the second sub-state are states of the electrical device in two dimensions, the state of the electrical device can be determined based on the first sub-state and the second sub-state. Because the first state information can indicate the first sub-state of the electrical device, and the second state information can indicate the second sub-state of the electrical device, the state of the electrical device can be determined based on the first state information and the second state information.

In this embodiment of the present disclosure, the overall profile information and the detail information are obtained based on the electrical data of the electrical device. Both the overall profile information and the detail information are shape information corresponding to the electrical data, indicating shape features of the curve corresponding to the electrical data. However, the shape features of the curves corresponding to the electrical data of the electrical device differ significantly in different states. Therefore, the sub-states of the electrical device can be determined from two dimensions based on the overall profile information and the detail information, to obtain the corresponding first state information and second state information, and the state of the electrical device can then be determined based on the first state information and the second state information. Because the combined overall profile information and detail information are highly distinctive for different states of the electrical device, the state of the electrical device can be recognized from two dimensions based on the overall profile information and the detail information, so that the state of the electrical device can be accurately determined, thereby ensuring accuracy of an obtained state recognition result.

In a possible implementation, when the overall profile information is determined, amplitude information and temporal information may be obtained based on the electrical data of the electrical device. The amplitude information is a feature or an electrical signal of the electrical device with significant patterns in different states, and the temporal information may be extracted from a specific electrical quantity. After the amplitude information and the temporal information are obtained, the overall profile information may be determined based on the amplitude information, and the detail information may be determined based on the amplitude information and the temporal information.

There may be one or more sources of the amplitude information, there may be one or more sources of the temporal information, and the sources of the amplitude information and the temporal information may be partially or entirely the same. A curve shape of the amplitude information has a unique pattern corresponding to a recognizable state of the electrical device. The temporal information is accurate in timing and easily distinguishable.

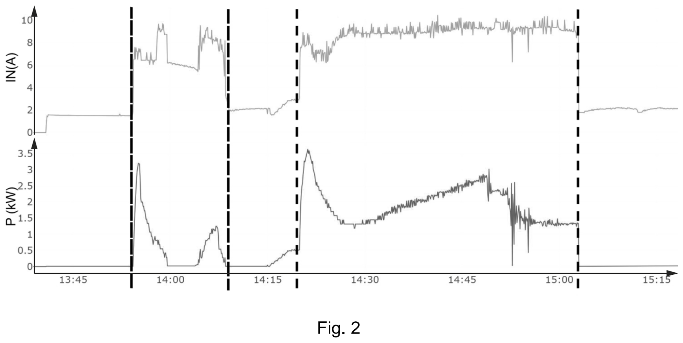

FIG. 2 is a schematic diagram of curves corresponding to active power and neutral current according to an embodiment of the present disclosure. In FIG. 2, the vertical axis P represents the active power of phase 2, with the unit of kilowatts (kW), the vertical axis IN represents the neutral current, with the unit of amperes (A), and the horizontal axis T represents time. As shown in FIG. 2, the neutral current shows significant abrupt changes over time. With respect to timing, the neutral current is more easily distinguishable than the active power (the active power of phase 2). Therefore, the neutral current may be used as temporal information. The active power can broadly reflect an overall shape of a curve corresponding to each piece of electrical data (such as active power, reactive power, and neutral current). Therefore, the active power may be used as amplitude information.

In this embodiment of the present disclosure, the amplitude information and the temporal information are obtained based on electrical data of an electrical device, so that the amplitude information can reflect the overall shape of the curve corresponding to the electrical data, and the temporal information can intuitively reflect a shape change of the curve corresponding to the electrical data. Then, overall profile information is determined based on the amplitude information, and detail information is determined based on the amplitude information and the temporal information, ensuring that the overall profile information can accurately indicate an overall profile of the curve corresponding to the electrical data, and the detail information can indicate details of the curve corresponding to the electrical data. Moreover, when a state of the electrical device is recognized based on the overall profile information and the detail information, accuracy of a state recognition result can be ensured.

In a possible implementation, both the amplitude information and the temporal information may be obtained by extracting curve shape features. Feature extraction may be performed on the electrical data through a first extraction algorithm, to obtain the amplitude information, and feature extraction may be performed on the electrical data through a second extraction algorithm, to obtain the temporal information. The first extraction algorithm may be a minimum filtering algorithm, a median filtering algorithm, a maximum filtering algorithm, a reshaping algorithm, or a mathematical morphology algorithm. The second extraction algorithm may be a filtering algorithm, a reshaping algorithm, or an event detection algorithm.

In this embodiment of the present disclosure, the amplitude information is extracted from the electrical data through the minimum filtering algorithm, the median filtering algorithm, the maximum filtering algorithm, the reshaping algorithm, or the mathematical morphology algorithm, so that the amplitude information can reflect the overall shape of the curve corresponding to the electrical data. The temporal information is extracted from the electrical data through the filtering algorithm, the reshaping algorithm, or he event detection algorithm, so that the temporal information can intuitively reflect a start position and an end position of the shape change of the curve corresponding to the electrical data. Therefore, after the overall profile information and the detail information are determined based on the amplitude information and the temporal information, it is ensured that a combination of the overall profile information and the detail information is highly distinctive for different states of the electrical device, thereby ensuring accuracy of the state recognition result obtained based on the overall profile information and the detail information.

In a possible implementation, a source of the amplitude information may include inactive power and reactive power, and a source of the temporal information may include neutral current. When the overall profile information is obtained based on the amplitude information, an envelope of the reactive power may be extracted as the overall profile information. When the detail information is obtained based on the amplitude information and the temporal information, a temporal feature may be extracted from the neutral current, a curve segment may be extracted from a curve corresponding to the active power based on the temporal feature, and the curve segment may then be determined as the detail information.

Because both the reactive power and the active power can indicate an overall profile of each piece of electrical data, the envelope of the reactive power can be extracted as the overall profile information, so that the overall profile information can indicate the overall profile of the curve corresponding to the electrical data.

The neutral current includes an easily distinguishable temporal feature, and the reactive power has been used to extract the overall profile information. To avoid information redundancy, based on the temporal feature extracted from the neutral current, a curve segment is extracted from the curve corresponding to the active power, and the curve segment is then determined as the detail information. The curve segment is a curve segment that is in the curve corresponding to the active power and that is distinctive for different states of the electrical device, and the temporal feature indicates a start time and an end time of the curve segment. As shown in FIG. 2, because the curve corresponding to the neutral current shows significant abrupt changes over time, the temporal feature may be extracted from the neutral current. The curve in FIG. 2 indicates the temporal feature, and the part that is between adjacent dashed lines and that is in the curve corresponding to the active power of phase 2 is the curve segment.

In this embodiment of the present disclosure, both the reactive power and the active power can indicate the overall profile of each piece of electrical data, and the neutral current includes the easily distinguishable temporal feature. An envelope of the active power is extracted as the overall profile information, and a curve segment in a curve corresponding to the reactive power is extracted as the detail information based on the temporal feature extracted from the neutral current, ensuring that the overall profile information can indicate the overall profile of the curve corresponding to the electrical data, and the detail information can indicate the details of the curve corresponding to the electrical data, and reduce redundant information in the overall profile information and the detail information, thereby ensuring accuracy of the state recognition result obtained based on the overall profile information and the detail information.

In a possible implementation, when first state information is determined based on the overall profile information, the overall profile information may be input into a predetermined clustering model, a target category to which the overall profile information belongs is determined through the clustering model, and state information corresponding to the target category is then determined as the first state information.

The clustering model may determine, from a plurality of categories, a category to which the input information belongs. The plurality of categories correspond to a plurality of first sub-states of the electrical device, and different categories correspond to different first sub-states. For example, if the electrical device is a high-temperature oven, and a clustering result of the clustering model includes two categories: the first sub-state corresponding to category 1 is a heating start phase of the electrical device, and the first sub-state corresponding to category 2 is a heating maintenance phase of the electrical device.

After the overall profile information is input into the clustering model, the clustering model may determine the target category to which the overall profile information belongs, and then determine the state information corresponding to the target category as the first state information. For example, after the overall profile information is input into the clustering model, if the clustering model determines that the overall profile information belongs to category 1, state information corresponding to category 1 (which indicates that the high-temperature oven is in the heating start phase) is determined as the first state information. If the clustering model determines that the overall profile information belongs to category 2, state information corresponding to category 2 (which indicates that the high-temperature oven is in the heating maintenance phase) is determined as the first state information.

The clustering model may be obtained through training using a plurality of pieces of historical electrical data of the electrical device. According to the manner of obtaining the overall profile information from the electrical data in the foregoing embodiment, sample overall profile information is obtained from the historical electrical data, and the clustering model is trained based on a plurality of pieces of sample overall profile information, so that the clustering model can determine the category to which the input information belongs. The clustering model may be obtained by training a Gaussian mixture module (GMM) and a random forest module.

In this embodiment of the present disclosure, the clustering model is pre-trained, and the clustering model can determine the category to which the input information belongs. Different categories correspond to different state information, and the different state information indicates different first sub-states of the electrical device. Therefore, after the overall profile information is input into the clustering model, the target category to which the overall profile information belongs can be determined, and the state information corresponding to the target category can then be determined as the first state information. Because the overall profile information is shape information of the electrical data, the first state information is determined based on the overall profile information in a clustering manner, thereby ensuring accuracy of the determined first state information.

In a possible implementation, when second state information is determined based on the detail information, a target reference curve with the highest similarity to a curve corresponding to the detail information may be determined from a plurality of reference curves, and state information corresponding to the target reference curve may then be determined as the second state information.

The plurality of reference curves are predetermined, the plurality of reference curves correspond to a plurality of second sub-states of the electrical device, and different reference curves correspond to different second sub-states. For example, if the electrical device is a high-temperature oven, three reference curves are predetermined: a second sub-state corresponding to reference curve 1 is that the electrical device is in a no-blowing state, a second sub-state corresponding to reference curve 2 is that the electrical device is operating at first-level blowing, and a second sub-state corresponding to reference curve 3 is that the electrical device is in operating at second-level blowing.

After the detail information is obtained, similarities between the curve corresponding to the detail information and the reference curves may be calculated through a dynamic time warping (DTW) algorithm or a variant/derivative algorithm thereof, the reference curve with the highest similarity to the curve corresponding to the detail information may be determined as the target reference curve, and the state information corresponding to the target reference curve may then be determined as the second state information. For example, after the similarities between the curve corresponding to the detail information and reference curves 1 to 3 are calculated through the DTW algorithm, if the similarity between the curve corresponding to the detail information and reference curve 1 is the highest, state information corresponding to reference curve 1 (which indicates that the high-temperature oven is in a no-blowing state) is determined as the second state information; if the similarity between the curve corresponding to the detail information and reference curve 2 is the highest, state information corresponding to reference curve 2 (which indicates that the high-temperature oven is operating at first-level blowing) is determined as the second state information; and if the similarity between the curve corresponding to the detail information and the reference curve 3 is the highest, state information corresponding to reference curve 3 (which indicates that the high-temperature oven is operating at second-level blowing) is determined as the second state information.

In an example, a plurality of pieces of historical electrical data of the electrical device are obtained. Sample detail information is obtained from the historical electrical data according to the manner of obtaining the detail information from the electrical data in the foregoing embodiment, and a plurality of reference curves are obtained through a similarity-based clustering algorithm such as a density peak clustering (DPC) algorithm or a shapelet algorithm.

In this embodiment of the present disclosure, the plurality of reference curves are predetermined, different reference curves correspond to different state information, and the different state information indicates different second sub-states of the electrical device. Similarities between the curve corresponding to the detail information and the reference curves are calculated, the target reference curve with the highest similarity to the curve corresponding to the detail information is determined from the plurality of reference curves, and the state information corresponding to the target reference curve is then determined as the second state information. Because the detail information is shape information of the electrical data, the second state information is determined based on the detail information by calculating the similarities between the curves, so that the target reference curve with the highest similarity to the curve corresponding to the detail information can be matched, and the state information corresponding to the target reference curve can then be determined as the second state information, thereby ensuring accuracy of the determined second state information.

In a possible implementation, after the first state information and the second state information are obtained, a state indicated by the first state information and a state indicated by the second state information may be combined, to obtain the state of the electrical device.

The first state information can indicate the first sub-state of the electrical device, and the second state information can indicate the second sub-state of the electrical device. The first sub-state and the second sub-state are states of the electrical device in two dimensions. Therefore, after the first state information and the second state information are obtained, the first sub-state indicated by the first state information may be combined with the second sub-state indicated by the second state information, to obtain the state of the electrical device.

In an example, if the electrical device is a high-temperature oven, the first state information indicates that the high-temperature oven is in a heating start phase, and the second state information indicates that the high-temperature oven is operating at first-level blowing. A state of the high-temperature oven is that the high-temperature oven is in the heating start phase and is operating at first-level blowing.

In this embodiment of the present disclosure, the first state information indicates the first sub-state of the electrical device, and the second state information indicates the second sub-state of the electrical device. The first sub-state and the second sub-state are combined to obtain the state of the electrical device, so that the state recognition result of the electrical device is more refined and comprehensive, thereby ensuring accuracy of the state recognition result of the electrical device.

In an example, electrical data of the high-temperature oven corresponds to continuously varying curves. The electrical data of the high-temperature oven is collected over three months through a smart meter. The electrical data includes active power, reactive power, neutral current, and the like. The collected electrical data may be divided into 23 segments, where each segment represents a complete operation, and each operation includes a plurality of states of the high-temperature oven. The 23 segments include a total of 155 states of the high-temperature oven. Through the state recognition method according to this embodiment of the present disclosure, 144 of these states can be accurately recognized, resulting in a state recognition accuracy of 93%.

In another example, electrical data of a cleaning device includes a part corresponding to continuously varying curves and a part corresponding to discontinuously varying curves. The electrical data of the cleaning device is collected over three months through a smart meter, to obtain 237 states of the cleaning device. Through the state recognition method according to this embodiment of the present disclosure, 236 of these states can be accurately recognized, resulting in a state recognition accuracy of 99%.

It can be known from the foregoing two validation examples that, for an electrical device whose electrical data corresponds to continuously varying curves, and for an electrical device whose electrical data corresponds to continuously varying curves and discontinuously varying curves, the state recognition method according to this embodiment of the present disclosure can recognize a state of the electrical device with high accuracy.

### Electrical device state recognition apparatus

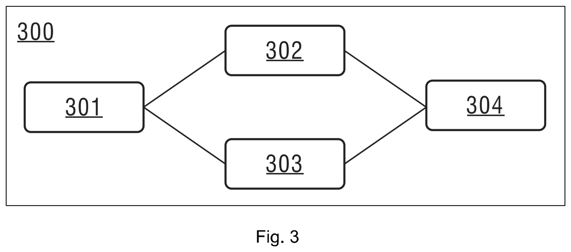

FIG. 3 is a schematic diagram of an electrical device state recognition apparatus according to an embodiment of the present disclosure. As shown in FIG. 3, the electrical device state recognition apparatus 300 includes:
an extraction unit 301, configured to obtain overall profile information and detail information based on electrical data of an electrical device, where the overall profile information is used to indicate an overall profile of a curve corresponding to the electrical data, and the detail information is used to indicate details of the curve;
a first mapping unit 302, configured to determine first state information of the electrical device based on the overall profile information;
a second mapping unit 303, configured to determine second state information of the electrical device based on the detail information; and
a recognition unit 304, configured to determine a state of the electrical device based on the first state information and the second state information.

In this embodiment of the present disclosure, the extraction unit 301 obtains the overall profile information and the detail information based on the electrical data of the electrical device. Both the overall profile information and the detail information are shape information corresponding to the electrical data, indicating shape features of the curve corresponding to the electrical data. However, the shape features of the curves corresponding to the electrical data of the electrical device differ significantly in different states. Therefore, the first mapping unit 302 can determine the first state information based on the overall profile information, the second mapping unit 303 can determine the second state information based on the detail information, and then the recognition unit 304 can determine the state of the electrical device based on the first state information and the second state information. Because the combined overall profile information and detail information are highly distinctive for different states of the electrical device, the state of the electrical device can be recognized from two dimensions based on the overall profile information and the detail information, so that the state of the electrical device can be accurately determined, thereby ensuring accuracy of an obtained state recognition result.

It should be noted that content such as interaction between the parts in the foregoing electrical device state recognition apparatus is based on the same concept as the foregoing embodiments of the electrical device state recognition method. For specific content and beneficial effects, reference may be made to the descriptions in the foregoing embodiments of the electrical device state recognition method. Details are not described herein again.

### Electronic device

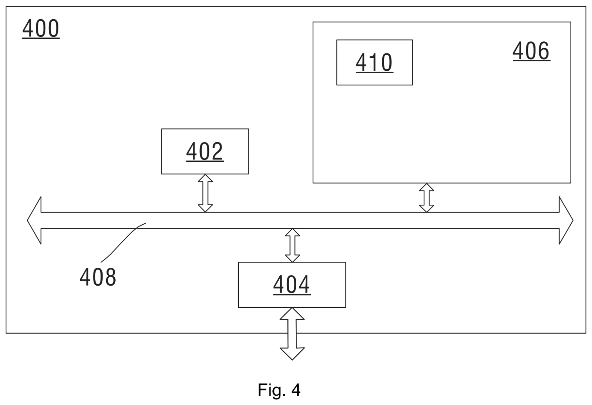

FIG. 4 is a schematic diagram of an electronic device according to an embodiment of the present disclosure. A specific implementation of the electronic device is not limited in specific embodiments of the present disclosure. Referring to FIG. 4, the electronic device 400 according to this embodiment of the present disclosure includes: a processor 402, a communication interface 404, a memory 406, and a bus 408. Specifically,
the processor 402, the communication interface 404, and the memory 406 communicate with each other via the bus 408.

The communication interface 404 is configured to communicate with another electronic device or server.

The processor 402 is configured to execute a program 410, and specifically, may perform related steps in the foregoing embodiments of the electrical device state recognition method.

Specifically, the program 410 may include program code, and the program code includes computer operation instructions.

The processor 402 may be a central processing unit (CPU) or an application specific integrated circuit (ASIC), or may be configured as one or more integrated circuits for implementing the embodiments of the present disclosure. One or more processors included in a smart device may be processors of the same type, for example, one or more CPUs; or may be processors of different types, for example, one or more CPUs and one or more ASICs.

The memory 406 is configured to store the program 410. The memory 406 may include a high-speed RAM memory, or may further include a non-volatile memory, for example, at least one magnetic disk memory.

The program 410 may be specifically configured to enable the processor 402 to perform the electrical device state recognition method according to any one of the foregoing embodiments.

For a specific implementation of steps in the program 410, reference may be made to the corresponding descriptions of the corresponding steps and units in the foregoing embodiments of the electrical device state recognition method. Details are not described herein again. A person skilled in the art can clearly understand that for convenience and conciseness of description, for specific working processes of the foregoing devices and modules, reference may be made to the corresponding process descriptions in the foregoing method embodiments. Details are not described herein again.

Through the electronic device according to this embodiment, overall profile information and detail information are obtained based on electrical data of an electrical device. Both the overall profile information and the detail information are shape information corresponding to the electrical data, indicating shape features of a curve corresponding to the electrical data. However, the shape features of the curves corresponding to the electrical data of the electrical device differ significantly in different states. Therefore, sub-states of the electrical device can be determined from two dimensions based on the overall profile information and the detail information, to obtain corresponding first state information and second state information, and a state of the electrical device can then be determined based on the first state information and the second state information. Because the combined overall profile information and detail information are highly distinctive for different states of the electrical device, the state of the electrical device can be recognized from two dimensions based on the overall profile information and the detail information, so that the state of the electrical device can be accurately determined, thereby ensuring accuracy of an obtained state recognition result.

### Computer-readable storage medium

The present disclosure further provides a computer-readable storage medium that stores instructions for causing a machine to perform the electrical device state recognition method described herein. Specifically, a system or an apparatus that is equipped with a storage medium may be provided. The storage medium stores software program code that implements functions of any one of the foregoing embodiments, and a computer (a CPU or an MPU) of the system or the apparatus is enabled to read and execute the program code stored in the storage medium.

In this case, the program code read from the storage medium can implement the functions in any one of the foregoing embodiments, and therefore the program code and the storage medium for storing the program code constitute a part of the present disclosure.

Embodiments of the storage medium for providing the program code include a floppy disk, a hard disk, a magneto-optical disk, an optical disk (for example, a CD-ROM, a CD-R, a CD-RW, a DVD-ROM, a DVD-RAM, a DVD-RW, or a DVD+RW), a magnetic tape, a non-volatile storage card, and a ROM. Optionally, the program code can be downloaded from a server computer through a communication network.

In addition, it should be clear that an operating system operated on the computer may be caused, not only by executing the program code read by the computer, but also by using instructions based on the program code, to implement some or all actual operations, thereby implementing the functions of any one of the foregoing embodiments.

In addition, it may be understood that the program code read from the storage medium is written into a memory that is disposed in an extension board inserted in the computer, or is written into a memory that is disposed in an extension module connected to the computer, and then the CPU or the like that is installed on the extension board or extension module may be caused to execute some or all actual operations based on instructions of the program code, thereby implementing the functions of any one of the foregoing embodiments.

### Computer program product

Embodiments of the present disclosure further provide a computer program product. The computer program product is tangibly stored on a computer-readable medium and includes computer-executable instructions. The computer-executable instructions, when executed, cause at least one processor to perform the electrical device state recognition method according to the foregoing embodiments. It should be understood that, each solution in this embodiment has a corresponding technical effect in the foregoing method embodiment. Details are not described herein again.

It should be noted that, not all steps and modules in the processes and the apparatus structure diagrams are necessary, and some steps or modules may be omitted according to an actual requirement. An execution order of the steps is not fixed and may be adjusted according to a requirement. The system structure described in the embodiments may be a physical structure or a logical structure. In other words, some modules may be implemented by the same physical entity, or some modules may be implemented by a plurality of physical entities, or may be implemented by some components in a plurality of independent devices together.

In this patent application, nouns and pronouns related to persons are not limited to a specific gender.

In the foregoing embodiments, the hardware modules may be implemented mechanically or electrically. For example, a hardware module may include a permanent dedicated circuit or logic (for example, a dedicated processor, an FPGA, or an ASIC) to complete a corresponding operation. The hardware module may further include a programmable logic or circuit (for example, a general-purpose processor or another programmable processor), which may be temporarily set by software to complete a corresponding operation. A specific implementation (a mechanical manner, a dedicated permanent circuit, or a temporarily set circuit) may be determined based on consideration of costs and time.

The present disclosure is shown and described in detail above through the accompanying drawings and preferred embodiments. However, the present disclosure is not limited to the disclosed embodiments. Based on the foregoing plurality of embodiments, a person skilled in the art may learn that code review means in the foregoing different embodiments may be combined to obtain more embodiments of the present disclosure. These embodiments also fall within the protection scope of the present disclosure.

## Claims

1. An electrical device state recognition method (100), comprising:
obtaining overall profile information and detail information based on electrical data of an electrical device, wherein the overall profile information is used to indicate an overall profile of a curve corresponding to the electrical data, and the detail information is used to indicate details of the curve;
determining first state information of the electrical device based on the overall profile information;
determining second state information of the electrical device based on the detail information; and
determining a state of the electrical device based on the first state information and the second state information.

2. The method according to claim 1, wherein the obtaining overall profile information and detail information based on electrical data of an electrical device comprises:
obtaining amplitude information and temporal information based on the electrical data of the electrical device;
obtaining the overall profile information based on the amplitude information; and
obtaining the detail information based on the amplitude information and the temporal information.

3. The method according to claim 2, wherein the obtaining amplitude information and temporal information based on the electrical data of the electrical device comprises:
performing feature extraction on the electrical data through a first extraction algorithm, to obtain the amplitude information, wherein the first extraction algorithm comprises at least one of a minimum filtering algorithm, a median filtering algorithm, a maximum filtering algorithm, a reshaping algorithm, or a mathematical morphology algorithm; and
performing feature extraction on the electrical data through a second extraction algorithm, to obtain the temporal information, wherein the second extraction algorithm comprises at least one of a filtering algorithm, a reshaping algorithm, or an event detection algorithm.

4. The method according to claim 2, wherein
the obtaining the overall profile information based on the amplitude information comprises: extracting an envelope of reactive power comprised in the amplitude information as the overall profile information; and
the obtaining the detail information based on the amplitude information and the temporal information comprises: extracting a temporal feature from neutral current comprised in the temporal information, extracting, based on the temporal feature, a curve segment from a curve corresponding to active power comprised in the amplitude information, and determining the curve segment as the detail information.

5. The method according to claim 1, wherein the determining first state information of the electrical device based on the overall profile information comprises:
inputting the overall profile information into a clustering model, to determine a target category to which the overall profile information belongs; and
determining state information corresponding to the target category as the first state information.

6. The method according to claim 1, wherein the determining second state information of the electrical device based on the detail information comprises:
determining, from a plurality of reference curves, a target reference curve with the highest similarity to a curve corresponding to the detail information; and
determining state information corresponding to the target reference curve as the second state information.

7. The method according to any one of claims 1 to 6, wherein the determining a state of the electrical device based on the first state information and the second state information comprises:
combining a state indicated by the first state information with a state indicated by the second state information, to obtain the state of the electrical device.

8. An electrical device state recognition apparatus (300), comprising:
an extraction unit (301), configured to obtain overall profile information and detail information based on electrical data of an electrical device, wherein the overall profile information is used to indicate an overall profile of a curve corresponding to the electrical data, and the detail information is used to indicate details of the curve;
a first mapping unit (302), configured to determine first state information of the electrical device based on the overall profile information;
a second mapping unit (303), configured to determine second state information of the electrical device based on the detail information; and
a recognition unit (304), configured to determine a state of the electrical device based on the first state information and the second state information.

9. An electronic device (400), comprising: a processor (402), a communication interface (404), a memory (406), and a bus (408), wherein the processor (402), the communication interface (404), and the memory (406) communicate with each other via the bus (408); and
the memory (406) is configured to store at least one executable instruction, wherein the executable instruction causes the processor (402) to perform operations corresponding to the electrical device state recognition method according to any one of claims 1 to 7.

10. A computer-readable storage medium, wherein the computer-readable storage medium stores computer instructions, and the computer instructions, when executed by a processor, cause the processor to perform the method according to any one of claims 1 to 7.

11. A computer program product, wherein the computer program product is tangibly stored on a computer-readable medium and comprises computer-executable instructions, and the computer-executable instructions, when executed, cause at least one processor to perform the method according to any one of claims 1 to 7.
